# FASCICULE DE BREVET EUROPEEN

(11) **EP 2 808 297 B1**
(45) Date de publication et mention de la délivrance du brevet: **05.02.2020**
(21) Numéro de dépôt: 14169829.0
(22) Date de dépôt: 26.05.2014
(51) Int. Cl.: B81C 1/00

(54) **Procédé de réalisation d'une partie suspendue d'une structure microélectronique et/ou nanoélectronique dans une partie monolithique d'un substrat**
Verfahren zur Herstellung eines frei hängenden Teils einer mikro- und/oder nanoelektronischen Struktur in einem monolithischen Teil eines Substrats
Methof for forming a suspended portion of a microelectronic and/or nanoelectronic structure in a monolithic part of a substrate

(30) Priorité: 28.05.2013 FR 1354801
(43) Date de publication de la demande: 03.12.2014
(73) Titulaire: Commissariat à l'Énergie Atomique et aux Énergies Alternatives, 75015 Paris (FR)
(72) Inventeur: Ben Mbarek, Sofiane, 38100 Grenoble (FR); Giroud, Sophie, 38120 Saint-Egreve (FR); Gaillard, Frédéric-Xavier, 38500 Voiron (FR)
(74) Mandataire: Ilgart, Jean-Christophe

(56) Documents cités:
- US-A- 4 437 226
- US-A- 5 235 187
- US-A- 5 719 073
- CULLIS A G ET AL: "THE STRUCTURAL AND LUMINESCENCE PROPERTIES OF POROUS SILICON", JOURNAL OF APPLIED PHYSICS, AMERICAN INSTITUTE OF PHYSICS, US, vol. 82, no. 3, 1 August 1997 (1997-08-01) , pages 909-965, XP000742441, ISSN: 0021-8979, DOI: 10.1063/1.366536

## Description

### DOMAINE TECHNIQUE ET ART ANTÉRIEUR

La présente invention se rapporte à un procédé de réalisation d'une structure comportant au moins une partie suspendue pouvant être mise en œuvre dans la réalisation de systèmes microélectromécaniques (MEMS ou "microelectromechanical systems" en terminologie anglo-saxonne) et/ou de systèmes nanoélectromécaniques (NEMS ou "nanoelectromechanical systems" en terminologie anglo-saxonne) pour la réalisation par exemple de capteurs ou d'actionneurs.

Les capteurs MEMS et NEMS comportent une partie fixe et au moins une partie suspendue par rapport à la partie fixe, la ou les parties suspendues étant aptes à se déplacer et/ou se déformer sous l'effet d'une action extérieure, telle qu'une action mécanique, électrique, magnétique.

Le déplacement et/ou la déformation de la partie mobile par rapport à la partie fixe permet de déterminer par exemple une accélération dans le cas d'un accéléromètre, une force de Coriolis dans le cas d'un gyromètre. Le déplacement de la partie mobile est par exemple mesuré au moyen de jauge de contrainte.

La majorité des procédés de réalisation ont recours à des substrats non monolithiques pour aboutir à des capteurs MEMS et/ou NEMS (substrat SOI par exemple). L'utilisation de ce type de substrat engendre un coût de revient important.

Le document *"*A new technology for micromachining of silicon: Dopant HF anodic etching for the realization of low-doped monocrystalline silicon structure", IEEE electron device letters (1990), Vol. 11, No. 12 décrit la réalisation d'une structure monocristalline suspendue en effectuant une étape d'implantation ionique de phosphore dans un substrat en p-Si de sorte à former des zones en n-Si destinées à former la structure suspendue et à réalisation d'une gravure dans le p-Si autour des zones en n-Si.

Ce procédé permet de réaliser une structure monolithique. Mais il requiert une étape d'implantation ionique. L'épaisseur des zones en n-Si et donc l'épaisseur de la structure suspendue sont déterminées par la profondeur d'implantation or celle-ci est difficilement contrôlable, ce qui peut conduire à une mauvaise définition de l'épaisseur de la structure suspendue.

Un autre de procédé désigné SCREAM pour « Single Reactive Etch and Metallization », présenté dans le document *"*SCREAM Micro ElectroMechanical Systems", Microelectronic Engineering 32 (1996) 49-73 utilise un substrat monolithique pour réaliser un composant MEMS et utilise une partie enterrée du substrat comme couche sacrificielle. Le procédé est composé des étapes de fabrication suivantes :
- Gravure DRIE de la structure MEMS
- Dépôt d'une couche d'oxyde,
- Gravure anisotrope de l'oxyde
- Gravure isotrope du silicium pour libérer le MEMS
- Métallisation de la structure au niveau des flancs et le dessus.

Ce procédé de réalisation prévoit la libération directe de l'élément suspendu ce qui va induire des effets néfastes sur l'élément libéré lors des étapes ultérieures visant à réaliser un ensemble intégré. Le document US 5 235 187 A décrit un procédé qui utilise également un substrat monolithique pour réaliser une poutre mobile.

### EXPOSÉ DE L'INVENTION

C'est par conséquent un but de la présente invention d'offrir un procédé de réalisation d'une structure suspendue à partir d'une partie monolithique d'un substrat, la structure pouvant être avantageusement monocristalline.

Le but précédemment énoncé est atteint par un procédé réalisant à partir d'une partie monolithique d'un substrat une première gravure sur une première profondeur pour définir la structure suspendue, un dépôt d'une couche de protection sur au moins les bords latéraux de la première gravure, une deuxième gravure sur une deuxième profondeur dans la première gravure, un traitement physicochimique d'au moins une partie de la zone située sous la structure suspendue de sorte à modifier celle-ci et à libérer la structure suspendue.

En d'autres termes, on réalise un première gravure pour définir la partie suspendue, cette partie suspendue étant protégée, on réalise ensuite une deuxième gravure dans la première gravure pour accéder à une zone du substrat située sous la partie suspendue, cette zone subissant un traitement physicochimique, cette zone est ensuite destinée à être retirée pour libérer la partie suspendue. Le retrait peut avoir lieu sur la zone ayant subi le traitement physicochimique ou après une oxydation de la zone traitée.

Dans la présente demande, on entend par "partie monolithique" une partie d'un substrat réalisée en un seul matériau présentant une seule structure cristallographique sans interface.

Dans la présente demande, on entend par traitement physicochimique, tout traitement apte à modifier localement un matériau en conservant sa nature. En d'autres termes, la nature de matériau avant et après ce traitement est identique. En corollaire, l'oxydation n'est pas considérée comme un traitement physicochimique à cause de la transformation du matériau en oxyde. Par exemple il peut s'agir d'un traitement visant à augmenter la porosité d'une zone de matériau telle que l'anodisation ou il peut s'agir d'un traitement visant à réduire la quantité de matériau de ladite zone telle que la gravure isotrope partielle. Ce traitement n'a pas pour but de libérer la partie suspendue mais de préparer la libération de la partie suspendue. D'une part, ce traitement permet un maintien mécanique de la zone suspendue lors d'étapes ultérieures de réalisation d'un composant. A l'inverse dans le cas d'une oxydation, le support de la structure à libérer serait complètements transformé en oxyde. Cette transformation complète créerait des contraintes mécaniques importantes qui influenceraient la morphologie de la structure cible. Grâce à l'invention, l'utilisation d'un traitement physicochimique intermédiaire permet de remédier à ce problème. D'autre part, le traitement facilite la libération ultérieure de ladite zone suspendue.

Dans un exemple de réalisation, le traitement physicochimique est une étape d'anodisation.

De manière très avantageuse, le partie monolithique est monocristalline et offre des propriétés électriques et mécaniques très avantageuses pour un capteur ou actionneur MEMS et/ou NEMS.

De préférence avant la libération de la partie suspendue, une étape d'oxydation a lieu. De manière très avantageuse, l'étape d'oxydation comporte une première sous-étape d'oxydation à une première température et une deuxième sous-étape d'oxydation à une deuxième température, la deuxième température étant supérieure à la première température, la première étape à température plus basse permet de réduire les risques de choc thermique qui pourraient déformer la couche traitée et freiner son oxydation complète.

Le procédé de réalisation permet également de réaliser directement des structures fonctionnelles intégrant des MEMS et/ou NEMS comportant au moins une partie suspendue réalisée par le procédé selon l'invention et au moins une autre partie suspendue. De manière très avantageuse, les libérations des deux parties suspendues sont simultanées.

La présente invention a alors pour objet un procédé de réalisation d'au moins une première partie suspendue d'une structure microélectronique ou nanoélectronique à partir d'une partie monolithique d'un premier substrat comprenant une face avant et une face arrière, ledit procédé comportant les étapes:
a) de réalisation dans la face avant d'une première gravure d'une première profondeur donnée de sorte à délimiter la première partie suspendue par des tranchées, les tranchées étant délimitées par des bords latéraux et un fond,
b) de dépôt d'un matériau de protection au moins sur les bords latéraux des tranchées formant les flancs de la première partie suspendue, ledit matériau de protection étant apte à protéger lesdits bords latéraux contre un traitement physicochimique ultérieur,
c) de réalisation d'une deuxième gravure au moins dans le fond des tranchées de sorte à obtenir des tranchées d'une deuxième profondeur supérieure à la première profondeur, les bords latéraux comportant alors une partie recouverte du matériau de protection et une partie non recouverte par le matériau de protection,
d) de réalisation d'un traitement physicochimique du premier substrat dans la partie des bords latéraux non recouverte par le matériau de protection de sorte à modifier au moins en partie une zone du substrat située à l'opposé de la face avant par rapport à la première partie suspendue, dite zone traitée, le traitement physicochimique étant choisi parmi un traitement électrochimique ou une gravure isotrope partielle,
e) de libération de la première partie suspendue par retrait d'au moins la zone traitée à l'étape d).

Le procédé de l'invention est réalisée dans une partie monolithique du substrat; autrement dit ce substrat peut-être monolithique ou composée d'une partie principalement monolithique associée en face arrière à d'autres couches qui n'interviennent pas dans la réalisation de la première partie suspendue, les différentes gravures des tranchées étant réalisée dans la partie monolithique

Dans un exemple, le traitement physicochimique est un traitement électrochimique qui peut être une anodisation.

Dans un autre exemple, le traitement physicochimique est une gravure isotrope partielle.

Le premier substrat peut avantageusement être en un matériau semi-conducteur monocristallin.

De manière très avantageuse, le procédé de réalisation peut comporter, entre l'étape d) et l'étape e), une étape d1) d'oxydation d'au moins la zone traitée et l'étape e) est une étape de retrait de la zone oxydée. L'étape d1) comporte préférentiellement une première sous-étape d'oxydation à une première température et une deuxième sous-étape d'oxydation à une deuxième température, la deuxième température étant supérieure à la première température.

La première température est par exemple comprise entre 400°C et 500°C et la deuxième température est par exemple supérieure à 500°C.

Dans un exemple de réalisation, lors de l'étape a), préalablement à la gravure, une autre couche de matériau de protection peut être déposée sur la face avant du premier substrat, ledit matériau de protection étant apte à protéger la face avant contre le traitement physicochimique de l'étape d).

Par exemple, le matériau de la ou des couches de protection est un matériau diélectrique ou un matériau métallique.

L'épaisseur de la ou des couches de protection peut être comprise entre quelques dizaines et quelques centaines de nanomètres.

Dans un autre exemple de réalisation, lors de l'étape a), préalablement à la première gravure, une première couche de résine est déposée sur la face avant du premier substrat, ladite première couche de résine étant retirée après la première gravure et avant l'étape b), et lors de l'étape c), préalablement à la deuxième gravure, une deuxième couche de résine est déposée sur la couche de matériau de protection, ladite deuxième couche de résine étant retirée après la deuxième gravure.

La présente invention a également pour objet un procédé de réalisation d'une structure microélectromécanique et/ou nanoélectromécanique comportant au moins une première et une deuxième partie suspendue, dans un ensemble comportant un premier substrat dont au moins la face avant est au moins en partie en matériau semi-conducteur, un deuxième substrat et des zones en matériau diélectrique et/ou des zones en matériau conducteur ou semi-conducteur situées à l'interface entre le premier substrat et le deuxième substrat, la première et la deuxième partie suspendue étant réalisées dans au moins une desdites faces du premier substrat, au moins la première partie suspendue étant obtenue suivant le procédé selon la présente invention.

Le deuxième substrat peut être reporté sur le premier substrat avant la réalisation de la deuxième partie suspendue par gravure, ladite deuxième partie étant réalisée en face avant ou en face arrière du premier substrat, lesdites première et deuxième parties étant libérées après le report du deuxième substrat sur le premier substrat.

La première partie suspendue est réalisée indifféremment avant ou après report du deuxième substrat.

Le procédé de réalisation peut comporter une étape de gravure du premier substrat au niveau de sa face arrière pour atteindre la zone traitée et/ou oxydée.

La libération de la première partie suspendue et la libération de la deuxième partie suspendue peuvent être simultanées et réalisées à partir de la face avant. Par exemple, les libérations de la première partie suspendue et de la deuxième partie suspendue s'effectuent par retrait d'oxyde.

La deuxième gravure de l'étape c) peut atteindre l'interface entre le premier et le deuxième substrat.

Dans un exemple de réalisation, le ou les matériaux de protection sont retirés à la fin de l'étape d1) et au moins l'extrémité ouverte des tranchées est bouchée préalablement à l'étape de réalisation de la deuxième partie suspendue lorsque les première et deuxième parties suspendues sont formées sur la face avant. Par exemple, l'extrémité ouverte des tranchées est bouchée par le dépôt d'un oxyde, avantageusement un oxyde TEOS. En variante, l'extrémité ouverte des tranchées est bouchée au moyen d'un film sec.

Dans un autre exemple de réalisation, la deuxième partie suspendue est réalisée par gravure en face arrière du premier substrat. Une couche d'oxyde peut alors être formée sur la face avant du premier substrat avant son assemblage avec le deuxième substrat, formant une couche d'arrêt pour la gravure de la deuxième partie suspendue. La libération de la première partie suspendue peut être obtenue par retrait de la zone traitée ou oxydée et la libération de la deuxième partie suspendue peut être obtenue par retrait de ladite couche d'oxyde, lesdites libérations étant simultanées.

### BRÈVE DESCRIPTION DES DESSINS

La présente invention sera mieux comprise à l'aide de la description qui va suivre et des dessins en annexes sur lesquels:
- les figures 1A à 1F sont des représentations schématiques de différentes étapes de réalisation d'une structure suspendue selon un procédé selon l'invention,
- les figures 2A à 2D sont des représentations schématiques d'une variante de réalisation du procédé des figures 1A à 1F,
- la figure 3 est une représentation schématique d'une variante de traitement physicochimique,
- les figures 4A à 4J sont des représentations schématiques de différentes étapes de réalisation d'un exemple d'un procédé de réalisation d'une structure MEMS et/ou NEMS fonctionnelle,
- les figures 5A à 5M sont des représentations schématiques de différentes étapes d'un procédé de réalisation d'une structure MEMS et/ou NEMS fonctionnelle selon un autre exemple de réalisation.

Les mêmes références seront utilisées pour désigner les mêmes éléments ayant sensiblement la même fonction dans les différents exemples de réalisation et les différentes variantes.

### EXPOSÉ DÉTAILLÉ DE MODES DE RÉALISATION PARTICULIERS

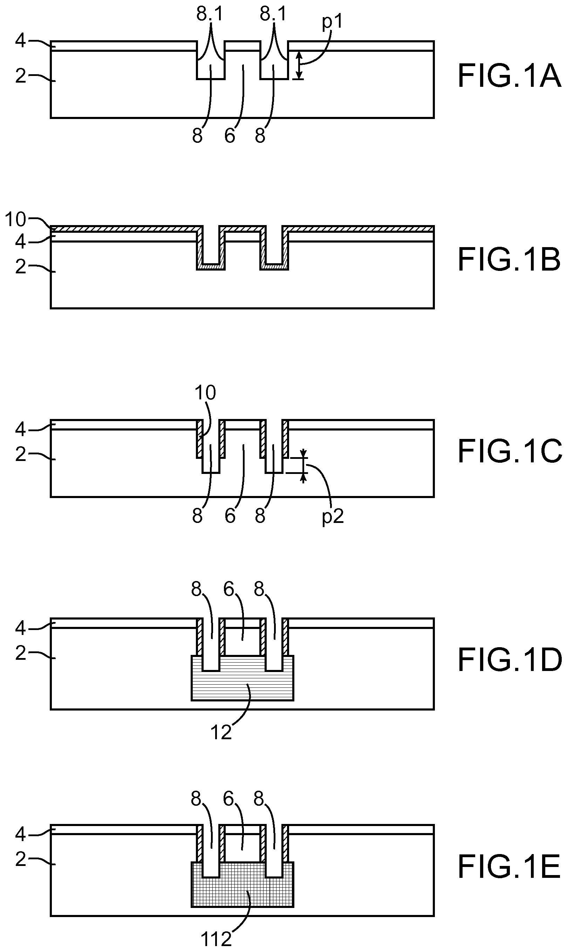

Sur les figures 1A à 1F sont représentées de manières schématiques les différentes étapes d'une partie suspendue selon un exemple de procédé de réalisation de l'invention.

Dans la présente demande, on désigne par " partie suspendue " d'une structure MEMS et/ou NEMS une partie susceptible de se déplacer et/ou se déformer sous l'effet d'une action extérieure (mécanique, électrique, magnétique,...) les expressions "partie suspendue", "élément suspendue", "zone suspendue" seront utilisées indifféremment dans la présente demande.

Dans la description qui va suivre et à des fins de simplicité, on prendra un substrat entièrement monolithique et en particulier l'exemple du silicium sera utilisé comme matériau semi-conducteur. Il est à noter que la mise en œuvre de tout autre matériau semi-conducteur ne sort pas du cadre de la présente invention, tel que le Ge, le SiGe, le SiC...

Le procédé selon l'invention utilise avantageusement un premier substrat 2 en silicium monocristallin.

Les étapes de procédé telle que représentées sur les figures 1A à 1F permettent de réaliser une partie suspendue, mais il sera compris que plusieurs parties suspendues peuvent être réalisées simultanément.

Lors d'une première étape, on forme une première couche barrière ou de protection 4 au moins sur les parties du substrat 2 exposées au traitement physicochimique qui sera effectué par la suite. Le matériau de la première couche barrière 4 est choisi de sorte à former une barrière au traitement physicochimique qui sera effectué par la suite. Cette couche barrière pourra être en matériau diélectrique, tel qu'un oxyde ou un nitrure, ou un matériau métallique. Selon le matériau chois, la couche barrière peut être déposée par différentes techniques telles que le dépôt chimique en phase vapeur (en anglais CVD (Chemical Vapor Déposition), le dépôt de couches minces atomiques (en anglais ALD (Atomic Layer Déposition)), le dépôt physique en phase vapeur (en anglais PVD (physical Vapor Déposition)). La première couche barrière 4 est par exemple en Si₃N₄ dans le cas d'un traitement physicochimique d'anodisation par l'acide fluorhydrique. La première couche barrière 4 présente par exemple une épaisseur comprise entre quelques dizaines et quelques centaines de nanomètres, par exemple une épaisseur égale à 200 nm.

Lors d'une étape suivante, les contours de la partie suspendue 6 sont définis dans le substrat 2 et la première couche barrière 4 en effectuant une lithographie puis en gravant ceux-ci sur une première profondeur p1, les gravures forment des tranchées 8. La gravure est par exemple une gravure ionique réactive ou RIE en anglais (Reactive Ion Etching). La profondeur p1 peut être comprise entre une centaine de nanomètres et plusieurs dizaines de micromètres.

Lors d'une étape suivante, une deuxième couche barrière 10 est formée de sorte à couvrir au moins les bords latéraux 8.1 des tranchées 8 afin de protéger les bords latéraux, en particulier la partie suspendue 6, de la deuxième gravure. Le matériau de la deuxième couche barrière 10 est choisi de sorte à former une barrière au traitement physicochimique qui sera effectué par la suite. Le matériau de la deuxième couche barrière pourra être choisi parmi des matériaux diélectriques tels que les oxydes, les nitrures ou des matériaux métalliques.

De préférence, la deuxième couche barrière 10 recouvre la première couche barrière 4, offrant ainsi une épaisseur suffisante de protection au substrat lors d'une deuxième gravure des tranchées.

De préférence, le matériau de la deuxième couche barrière 10 est identique à celui de la première couche barrière 4, mais un matériau différent pourrait être envisagé.

La deuxième couche barrière 10 présente par exemple une épaisseur comprise entre quelques dizaines et quelques centaines de nanomètres, par exemple égale à 100 nm. Dans l'exemple représenté, la deuxième couche barrière 10 recouvre également le fond des tranchées 8. La deuxième couche barrière ainsi déposée sur les flancs des tranchées, 8.1 est destinée à définir l'épaisseur de la partie suspendue 6 qui est représentée en pointillées. Selon le matériau choisi, la deuxième couche barrière peut être déposée par différentes techniques telles que le dépôt chimique en phase vapeur (en anglais CVD (Chemical Vapor Déposition, le dépôt de couches minces atomiques (en anglais ALD (Atomic Layer Déposition)), le dépôt physique en phase vapeur (en anglais PVD (physical Vapor Déposition)).

L'élément ainsi obtenu est représenté sur la figure 1B.

Lors d'une étape suivante, une seconde gravure a lieu dans les tranchées 8 de sorte à augmenter la profondeur des tranchées sur une deuxième profondeur donnée p2. Du fait de la présence de la deuxième couche barrière 10, les bords latéraux des tranchées 8 sur la profondeur p1 ne sont pas gravés par cette deuxième gravure. Cette seconde gravure est par exemple une gravure RIE... La profondeur p2 peut être comprise entre une centaine de nm et plusieurs dizaines de µm. Lors de cette deuxième gravure au moins une partie de la deuxième couche barrière 10 située sur la face avant du substrat 2 est consommée, mais du fait de la présence de la première couche barrière 4, tout risque de gravure de la face avant du substrat 2 est évité. Dans l'exemple représenté, toute la deuxième couche barrière 10 a été consommée en face avant.

L'élément ainsi obtenu est représenté sur la figure 1C.

Lors d'une étape suivante, un traitement physicochimique est appliqué à l'élément de la figure 1C, plus particulièrement à la zone du substrat 2 située sous la partie suspendue 6, cette zone est désignée 12. Le traitement physicochimique modifie localement le substrat 2 au moins une partie de la zone 12 au niveau de la portion des bords latéraux des tranchées non recouverts de la deuxième couche barrière 10.

Par exemple, ce traitement physicochimique est un traitement électrochimique agissant sur les parois latérales des tranchées 8. Ce traitement est par exemple une anodisation, par exemple dans une solution à base de acide fluorhydrique 30% avec application d'un courant de 100 mA. Dans le cas de l'anodisation, la zone 12 présente une porosité augmentée.

L'élément ainsi obtenu est représenté sur la figure 1D.

Lors d'une étape suivante, la partie suspendue 6 est libérée par retrait de la zone de substrat traitée située sous la partie suspendue 6. Cette libération peut être obtenue en gravant directement la zone traitée par exemple par une gravure par voie sèche ou humide, libérant la partie suspendue 6.

De manière avantageuse, préalablement à cette étape de libération, a lieu une étape d'oxydation, par exemple une oxydation thermique.

Cette étape supplémentaire d'oxydation permet de préparer la libération de la partie suspendue et de maintenir mécaniquement la partie suspendue jusqu'à sa libération.

De manière préférée, l'étape d'oxydation comprend deux sous-étapes, une première sous-étape à basse température et une deuxième sous-étape à haute température.

La première sous-étape, qui correspond à une pré-oxydation, a par exemple lieu à une température comprise entre 400°C et 500°C, ce qui permet de stabiliser la structure initiale de la zone traitée 12 contre des transformations irréversibles lors du traitement thermique élevé de la deuxième sous-étape.

En l'absence de cette première sous-étape, il se peut qu'une oxydation directe à des températures élevées, i.e. supérieures à 500°C fasse subir au silicium poreux un choc thermique engendrant une déformation de la morphologie de la couche poreuse, qui pourrait freiner une oxydation complète.

La deuxième sous-étape est une oxydation à une température plus élevée, i.e. supérieure à 500°C.

L'élément ainsi obtenu est représenté sur la figure 1E. La zone oxydée est désignée 112.

Ensuite, le silicium poreux oxydé est éliminé, par exemple par une gravure par voie humide à l'acide fluorhydrique, libérant la partie suspendue 6.

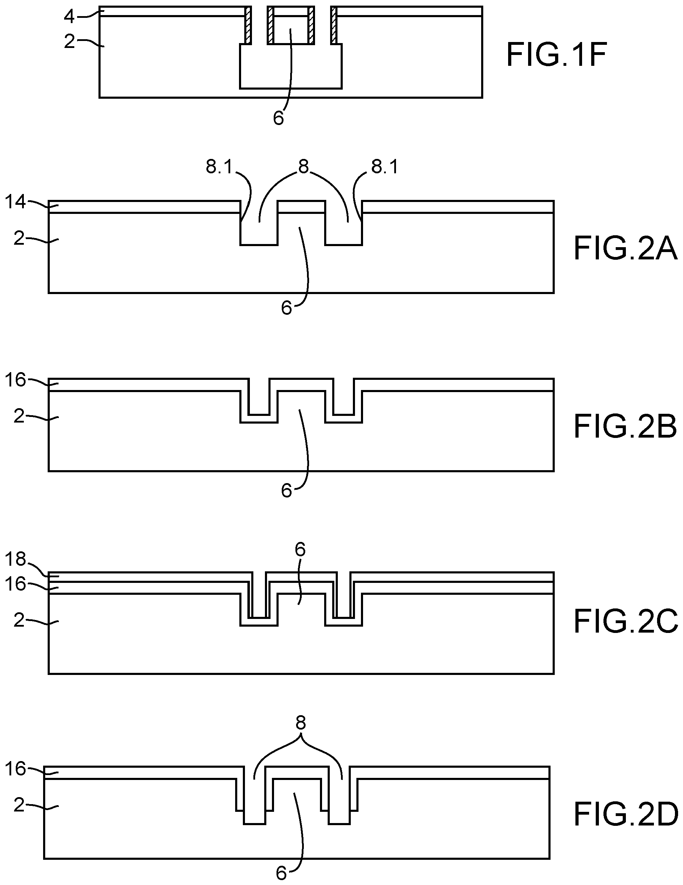

L'élément ainsi obtenu est représenté sur la figure 1F.

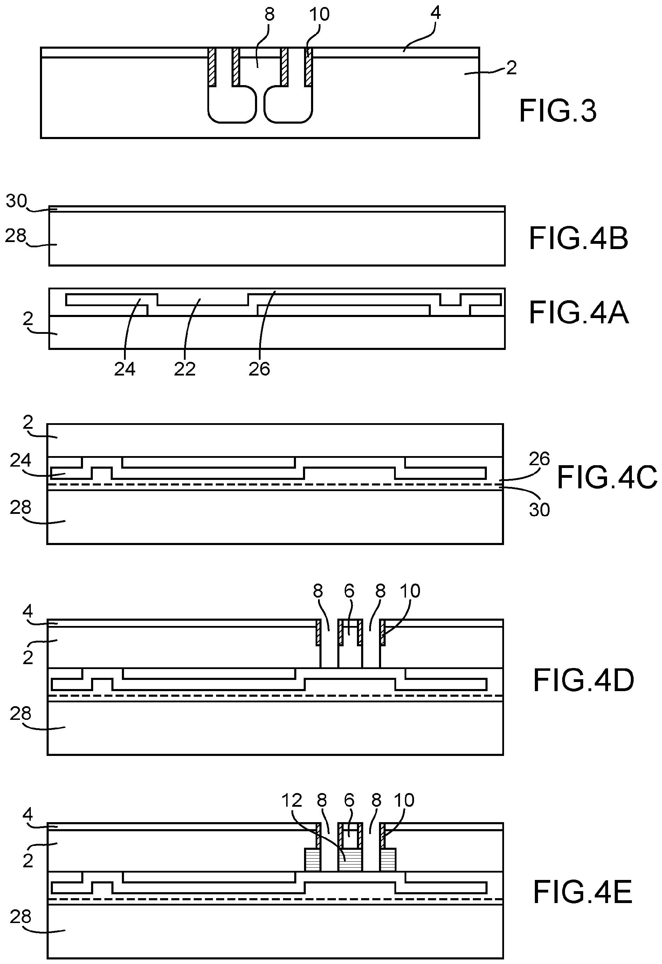

En variante, le traitement physicochimique local est une gravure isotrope partielle. Cette gravure peut être une gravure par voie sèche ou humide. L'élément ainsi obtenu est représenté sur la figure 3. Dans ce cas, la zone 12 est partiellement gravée, la quantité de matériau à retirer pour la libération finale est alors réduite. La partie suspendue est maintenue mécaniquement jusqu'à sa libération. Le matériau restant sous la partie suspendue peut être avantageusement oxydée, par exemple par une oxydation thermique. Dans ce cas une oxydation en une seule étape et non en deux sous-étapes est suffisante.

Comme on peut le voir représenté schématiquement sur la figure 3, la gravure isotrope a tendance à provoquer une gravure de la partie inférieure de la partie suspendue. On prévoit alors, lors de la première gravure, de réaliser des tranchées dont la profondeur est supérieure à l'épaisseur souhaitée pour la partie suspendue afin de compenser la perte de matière due à la gravure isotrope partielle.

Sur les figures 2A à 2D, on peut voir représentée schématiquement une variante des étapes 1A à 1C.

Lors d'une première étape, une couche de résine 14 est déposée sur le substrat 2 et une lithographie est réalisée définissant dans la première couche de résine 14 les contours de la partie suspendue 6. La résine mise en œuvre peut être une résine utilisée classiquement dans les procédés de photolithographie en microélectronique et nanoélectronique.

Lors d'une étape suivante, une première gravure a lieu formant des tranchées 8 délimitant la partie suspendue 6.

L'élément ainsi obtenu est représenté sur la figure 2A.

Lors d'une étape suivante, la couche de résine est retirée et une couche barrière 16 est déposée sur la surface supérieure du substrat et sur les bords latéraux 8.1 des tranchées 8. Dans l'exemple représenté, la couche barrière 16 recouvre le fond des tranchées 8 également. La couche barrière a les mêmes caractéristiques que celles des couches barrières mise en œuvre dans le procédé des figures 1A à 1F, elle est par exemple en Si₃N₄.

L'élément ainsi obtenu est représenté sur la figure 2B.

Lors d'une étape suivante, une autre couche de résine 18 est déposée sur la couche barrière 16.

Lors d'une étape suivante, la couche de résine subit une lithographie de sorte à dégager le fond des tranchées 8 et donc la couche barrière 16 recouvrant le fond des tranchées.

L'élément ainsi obtenu est représenté sur la figure 2C.

Lors d'une étape suivante, on réalise une deuxième gravure du substrat à partir du fond des tranchées en ayant préalablement gravé les portions de couche barrière recouvrant le fond des tranchées. Cette gravure est par exemple réalisée par un procédé de RIE... Du fait de la présence de la deuxième couche de résine 18 sur la face avant du substrat 2, la couche barrière 16 est protégée et on évite un risque de gravure de la face avant du substrat 2.

Lors d'une étape suivante, la couche de résine 18 est retirée.

L'élément ainsi obtenu est représenté sur la figure 2D.

Les étapes suivantes sont similaires aux étapes 1D, 1E et 1F et ne seront pas répétées.

Cette variante présente l'avantage d'éviter un double dépôt de couche barrière, ce qui permet de limiter les contraintes qui peuvent être induites par ce dépôt et de protéger les bords latéraux 8.1 lors de la gravure du fond des tranchées.

Le procédé selon l'invention mettant en œuvre une étape de traitement physicochimique après une gravure en deux étapes, permet de réaliser une partie suspendue dont le matériau est le même que la partie fixe ou support. En outre, en choisissant un substrat monocristallin, il est possible d'obtenir aisément une partie suspendue en matériau monocristallin dont les propriétés mécaniques et électriques sont particulièrement intéressantes pour un actionneur ou un capteur MEMS et/ou NEMS

En outre, ce procédé évite de devoir recourir à une ou des étapes de dépôt par épitaxie et à une ou des étapes d'implantation ionique.

En outre, l'étape d'oxydation préalablement à la libération permet, dans le cas d'une intégration complète dans laquelle au moins une autre partie suspendue est réalisée, de libérer simultanément et par le même procédé les différentes parties suspendues.

L'étape d'oxydation en deux sous-étapes, permet d'assurer une morphologie de la partie suspendue.

En outre, de manière avantageuse, le procédé selon l'invention ne requiert pas de substrat SOI, ce qui permet de réduire le coût de fabrication.

Enfin, le procédé selon l'invention offre la possibilité d'une intégration tridimensionnelle.

Sur les figures 4A à 4I, on peut voir un exemple de réalisation d'une structure MEMS et/ou NEMS fonctionnelle intégrant plusieurs parties suspendues. Le procédé qui va être décrit permet de réaliser une structure comportant deux éléments suspendus, la partie suspendue 6 et par exemple une masse suspendue. Le procédé permet donc de réaliser sur un même substrat une structure intégrant au moins un MEMS et/ou au moins un NEMS.

D'une part, on forme en face arrière d'un premier substrat 2 en Si, SiGe Ge SiC... une couche diélectrique, par exemple en oxyde 22.

Lors d'une étape suivante, on forme une couche par exemple en silicium polycristallin 24 sur la couche d'oxyde de sorte que la couche 24 soit en contact partiellement avec le premier substrat 2. Pour cela la couche d'oxyde 22 est structurée de sorte à atteindre le premier substrat 2 dans différentes zones, puis la couche de silicium polycristallin 24 est déposée.

Une autre couche d'oxyde 26 peut être déposée sur la couche structurée 24 formant une couche planarisante.

Plusieurs interconnexions peuvent être empilées.

On obtient l'empilement représenté sur la figure 4A.

D'autre part, on réalise un deuxième substrat 28 représenté sur la figure 4B. Celui-ci est choisi dans la famille des semi-conducteurs tels que le Si, SiGe, Ge, SiC et peut être en un matériau différent de celui du premier substrat. Une couche d'oxyde 30 peut être déposée au moins en face avant du deuxième substrat 28.

Les deux empilements sont ensuite scellés par les couches d'oxyde 26 et 30. On réalise alors un scellement oxyde-oxyde. Dans le cas où le premier substrat ne comporte pas de couche planarisante 26, le scellement est un scellement sur cavité silicium-oxyde, et plus généralement un scellement sur cavité semi-conducteur-oxyde.

Les techniques de scellement oxyde-oxyde ou semi-conducteur-oxyde sont bien connues de l'homme du métier et ne seront pas décrites.

Les différentes couches réalisées peuvent avoir des épaisseurs comprises entre quelques dizaines de nanomètres à quelques micromètres.

Lors d'une étape suivante, l'élément ainsi obtenu peut être aminci par la face avant du premier substrat 2 pour atteindre une épaisseur par exemple comprise entre environ 5 µm et environ 100 µm

L'élément ainsi obtenu est représenté sur la figure 4C. Le premier substrat 2 est situé en partie supérieure et le deuxième substrat est en partie inférieure.

Lors d'une étape suivante, on forme une première couche barrière 4 en face avant de l'élément de la figure 4C, par exemple une couche de nitrure tel que le Si₃N₄, par exemple dont l'épaisseur est de 200 nm. La couche barrière est par exemple réalisée par un dépôt chimique en phase vapeur à basse pression ou LPCVD en anglais (Low-Pressure Chemical Vapor Déposition).

Lors d'une étape suivante, on définit la partie suspendue par exemple en réalisant une lithographie sur la première couche barrière 4. Par exemple, on définit une partie suspendue 6 ayant une largeur comprise entre 0,2 µm et 5 µm et une longueur comprise entre 1 µm et 20 µm.

Lors d'une étape suivante, on grave la couche barrière 10 avec arrêt sur le premier substrat 2.

Lors d'une étape suivante, une deuxième couche barrière 10 est déposée au moins sur les bords latéraux des tranchées, par exemple sur une épaisseur de 50 nm. La deuxième couche barrière 10 est par exemple également en nitrure tel que le Si₃N₄.

Lors d'une étape suivante, on effectue une deuxième gravure du fond des tranchés 8 avec arrêt dans l'interface entre les premier et deuxième substrats.

L'élément ainsi obtenu est représenté sur la figure 4D.

Lors d'une étape suivante, on applique un traitement physicochimique au moins à la zone du premier substrat 2 située sous la partie suspendue 6. Il s'agit par exemple d'un traitement électrochimique, tel que par exemple une anodisation. L'anodisation est par exemple réalisée avec une solution d'acide fluorhydrique.

L'élément ainsi obtenu est représenté sur la figure 4E.

Lors d'une étape suivante, on effectue avantageusement une oxydation de la zone 12 préalablement traitée, par exemple une oxydation thermique. De manière préférée, l'oxydation a lieu en deux sous-étapes comme décrite en relation avec la figure 1E. Cette étape d'oxydation permet d'assurer le maintien de la partie suspendue jusqu'à la libération finale de tous les éléments suspendus, ce qui simplifie les différentes étapes suivantes du procédé. En outre, la libération simultanée de la partie suspendue et de la masse suspendue qui va être réalisée ci-dessous, peut être effectuée par une même étape de gravure unique d'oxyde. L'étape de libération est donc simplifiée. La zone oxydée est désignée 112.

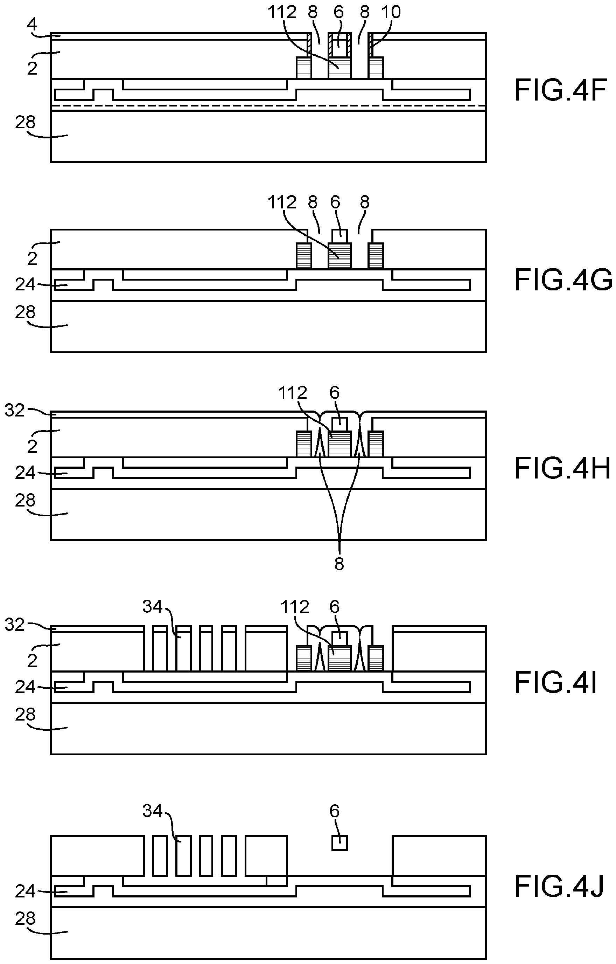

L'élément ainsi obtenu est représenté sur la figure 4F.

De manière avantageuse, mais non nécessaire, lors d'une étape suivante, les deux couches barrières sont retirées, par exemple par gravure chimique à base de H₃PO₄ dans le cas de couches barrières en Si₃N₄, par exemple

L'élément ainsi obtenu est représenté sur la figure 4G.

Lors d'une étape suivante, on forme une couche 32 destinée à obturer les tranchées afin de protéger la partie suspendue 6. Par exemple la couche 32 est une couche d'oxyde, réalisée au moins au niveau des tranchées 8 situées de part et d'autre de la partie suspendue 6. Cette couche d'oxyde 32 est formée par exemple par dépôt. La couche d'oxyde 32 est avantageusement déposée par dépôt chimique en phase vapeur assisté par plasma, à partir de tétraéthoxysilane (TEOS) dans un plasma oxygène ou oxygène-argon.

Dans l'exemple représenté, la couche 32 recouvre également la face avant de l'élément, mais comme cela a été expliqué ci-dessus ceci n'est pas limitatif. L'élément ainsi obtenu est représenté sur la figure 4H.

En variante, au lieu de former une couche d'oxyde 32 pour obstruer les tranchées, on met en œuvre un film sec photosensible déposé par une technique de laminage de films. Celui-ci pourra si besoin être retiré en partie grâce à une étape de photolithographie standard pour ne le laisser que au moins sur les tranchées à obstruer.

Lors d'une étape suivante, on réalise une deuxième partie suspendue 34, par exemple une masse suspendue 34, en gravant le premier substrat 2 à travers la couche d'oxyde 32. Dans l'exemple représenté, lors de cette étape de gravure, les bords latéraux des tranchées 8 sont également gravés. On peut envisager de réaliser une gravure de sorte à ne graver que le premier substrat 2 pour réaliser la masse suspendue sans graver les bords latéraux de tranchées 8.

L'élément ainsi obtenu est représenté sur la figure 4I.

Lors d'une étape suivante, on libère à la fois la partie suspendue 34 et la partie suspendue 6 en gravant l'oxyde situé sous la masse suspendue 32 et l'oxyde supportant la partie suspendue 6, oxyde qui a été formé après l'étape de traitement physicochimique. Cette gravure est par exemple une gravure au temps à l'acide fluorhydrique.

L'élément ainsi obtenu est représenté sur la figure 4J.

Ce procédé permet de réaliser un ensemble des plusieurs parties suspendues simultanément par exemple une structure MEMS et une structure NEMS intégrées.

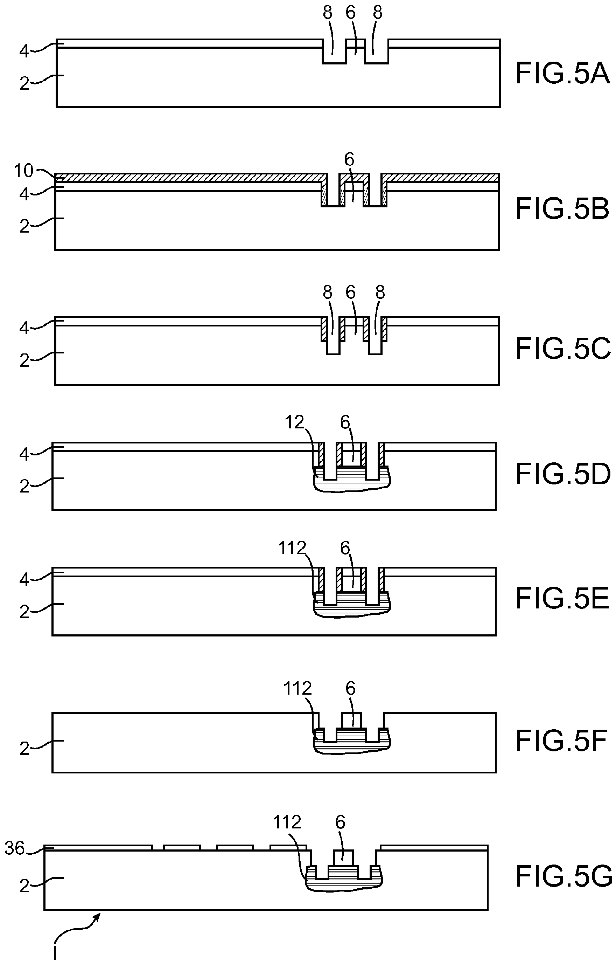

Nous allons maintenant décrire un procédé de réalisation d'un ensemble MEMS et/ou NEMS selon un autre exemple de réalisation. Les étapes de cet exemple sont représentées sur les figures 5A à 5M.

D'une part, on réalise un premier élément comportant la partie suspendue 6. Les étapes 5A à 5D sont similaires aux étapes 1A à 1D et ne seront pas décrites à nouveau. Ce procédé diffère de celui représenté sur la figures 4A à 4J notamment en ce que la première partie suspendue 6 est réalisée au moins en partie dans le premier substrat 2 avant l'assemblage du premier et du deuxième substrat.

De manière avantageuse, le procédé comporte une phase d'oxydation de la zone traitée 12, avantageusement suivant les deux sous-étapes décrites précédemment. La zone oxydée 112 située sous la partie suspendue 6 est conservée pour former un maintien mécanique jusqu'à la libération complète de tous les éléments suspendus. L'élément obtenu est représenté sur la figure 5E.

Lors d'une étape suivante, les première et deuxième couches barrières 4, 10 sont avantageusement retirées. Cette étape n'est pas nécessaire. L'élément ainsi obtenu est représenté sur la figure 5F.

Lors d'une étape suivante, une couche d'oxyde 36 peut être déposée sur la face avant du premier substrat 2 pour servir de couches de scellement avec le deuxième substrat et de couche d'arrêt à une future gravure. Le couche d'oxyde 36 peut être avantageusement structurée pour conserver des portions d'oxyde uniquement dans les zones de scellement avec le deuxième substrat et à l'aplomb des éléments suspendus qui vont être réalisés ultérieurement.

L'élément ainsi obtenu est représenté sur la figure 5G et est désigné I.

D'autre part, sur un deuxième substrat 40 on forme une couche en matériau diélectrique 42, par exemple de l'oxyde obtenu par oxydation thermique, sur sa face avant.

Lors d'une étape suivante, on dépose une couche conductrice 44, par exemple en Si qui pourra servir par exemple d'électrode. La couche 42 est de préférence structurée de sorte que la couche conductrice 44 soit en contact direct avec le deuxième substrat 40. La couche conductrice 44 peut être gravée.

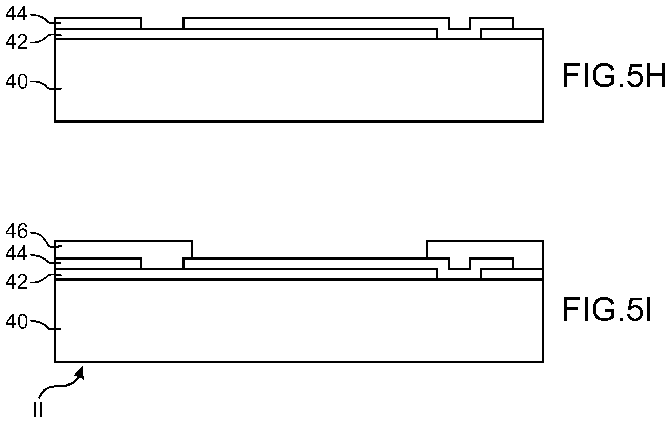

L'élément ainsi obtenu est représenté sur la figure 5H.

Une couche diélectrique 46, de préférence en oxyde est formée sur la couche conductrice 44. La couche diélectrique 46 est par exemple formée par oxydation ou par dépôt d'une couche d'oxyde par exemple par PECVD. Cette couche peut être avantageusement gravée à l'aplomb des premières et deuxièmes parties suspendues permettant de libérer toutes ou une partie des futures zones suspendues.

L'élément ainsi obtenu est représenté sur la figure 5I et est désigné II.

On peut envisager de réaliser un empilement alternant des couches diélectriques et des couches conductrices, les couches conductrices étant en contact entre elles et/ou avec le deuxième substrat de sorte à créer différents niveaux d'interconnexions électriques.

Lors d'une étape suivante, les deux éléments I et II sont assemblés par mise en contact de leur face avant et par exemple par scellement direct.

Dans le cas où les deux éléments comportent chacun sur leur face avant une couche d'oxyde, l'assemblage est obtenu par un scellement dit oxyde sur oxyde. Dans le cas où seul l'un des éléments comporte une couche d'oxyde en face avant et l'autre comporte une face avant en silicium, l'assemblage est obtenu par un scellement dit oxyde sur silicium. Il sera compris que dans le cas où la face avant est en un matériau autre que le silicium, par exemple en Ge, l'assemblage serait un assemblage oxyde sur Ge.

Le scellement est fait en partie sur des cavités quelque soit la configuration, il peut s'agir d'un scellement oxyde sur oxyde, oxyde sur semi-conducteur, tel que oxyde sur Si...

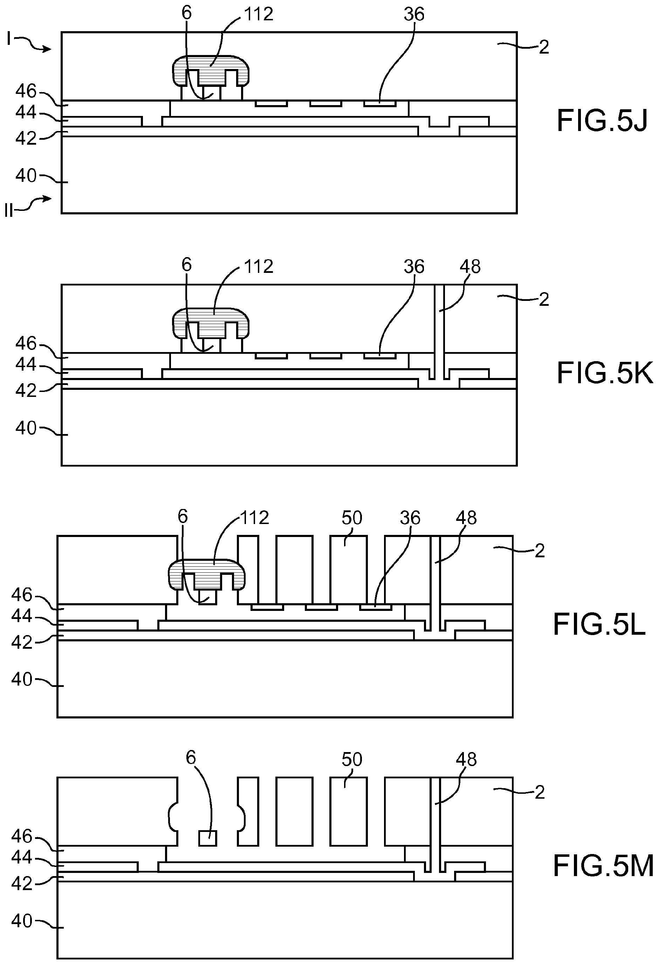

L'élément ainsi obtenu est représenté sur la figure 5J.

Lors d'une étape suivante, le premier substrat 2 peut être aminci par sa face arrière, par exemple par des techniques de grinding et planarisation pour définir l'épaisseur du deuxième élément suspendu. Le premier substrat peut être aminci pour atteindre une épaisseur comprise entre 5 µm et environ 100 µm.

Il peut être prévu de réaliser des connexions entre les différents éléments du futur composant, à savoir le premier substrat, le deuxième substrat et la/les couche(s) conductrice(s) déposée(s) sur le deuxième substrat. Dans l'exemple de réalisation représenté, une connexion au moyen d'un via 48 entre le premier substrat et la/les couche(s) conductrice(s) déposée(s) et le deuxième substrat est réalisée. Le via 48 est réalisé suivant des techniques connues par l'homme du métier. Il sera compris que plusieurs via peuvent être réalisés. D'autres techniques de connexion peuvent être mises en œuvre.

L'élément ainsi obtenu est représenté sur la figure 5K.

Lors d'une étape suivante, on réalise un autre élément suspendu 50 par exemple une masse suspendue d'un MEMS ou d'un NEMS. Pour cela on réalise des étapes de lithographie et gravure; de préférence il s'agit d'une gravure ionique réactive profonde ou gravure DRIE (en anglais Deep Reactive Ion Etching DRIE). On peut noter que dans l'exemple représenté la gravure DRIE s'arrête dans la couche d'oxyde 36 avantageusement préparée sur le substrat 2. La présence de la couche d'oxyde permet d'éviter que la gravure DRIE, qui est difficile à contrôler, débouche directement dans une cavité. Il y aurait sinon un risque de casse de la structure suspendue. De plus la couche d'oxyde 36 permet d'arrêter la gravure DRIE et de ne pas graver ou altérer la couche 44 qui dans l'exemple est en polysilicium qui est gravable par la DRIE.

L'élément ainsi obtenu est représenté sur la figure 5L.

Lors d'une étape suivante, on libère complètement les zones suspendues 6, 50 en éliminant l'oxyde maintenant la partie suspendue et l'oxyde liant la masse suspendue au substrat. Cette libération est par exemple obtenue au moyen d'acide fluorhydrique.

L'élément ainsi obtenu est représenté sur la figure 5M.

Il sera compris que la gravure isotrope partielle peut être appliquée aux procédés représentés sur les figures 2A à 2D, 4A à 4J et 5A à 5M. De même, les étapes 2A à 2D mettant en œuvre des première et deuxième couches de résine peut être mise en œuvre dans les procédés des figures 4A à 4J et 5A à 5M

Le procédé selon l'invention est particulièrement intéressant pour réaliser des éléments suspendus monocristallins monolithiques avec le substrat et permet de réaliser relativement facilement des structures intégrant des MEMS et/ou des NEMS.

## Revendications

1. Procédé de réalisation d'au moins une première partie suspendue d'une structure microélectronique ou nanoélectronique à partir d'une partie monolithique d'un premier substrat (2) comprenant une face avant et une face arrière, ledit procédé comportant les étapes:
a) de réalisation dans la face avant d'une première gravure d'une première profondeur (p1) donnée de sorte à délimiter la première partie suspendue (6) par des tranchées (8), les tranchées (8) étant délimitées par des bords latéraux (8.1) et un fond,
b) de dépôt d'un matériau de protection (10, 16) au moins sur les bords latéraux des tranchées (8) formant les flancs de la première partie suspendue (6), ledit matériau de protection étant apte à protéger lesdits bords latéraux contre un traitement physicochimique ultérieur,
c) de réalisation d'une deuxième gravure au moins dans le fond des tranchées (8) de sorte à obtenir des tranchées d'une deuxième profondeur (p2) supérieure à la première profondeur (p1), les bords latéraux comportant alors une partie recouverte du matériau de protection et une partie non recouverte par le matériau de protection,
d) de réalisation d'un traitement physicochimique du premier substrat (2) dans la partie des bords latéraux non recouverte par le matériau de protection de sorte à modifier au moins en partie une zone du substrat située à l'opposé de la face avant par rapport à la première partie suspendue (6), dite zone traitée (12),
e) de libération de la première partie suspendue (6) par retrait d'au moins la zone traitée à l'étape d),
le procédé étant **caractérisé en ce que** le traitement physicochimique est choisi parmi un traitement électrochimique ou une gravure isotrope partielle.

2. Procédé de réalisation selon la revendication 1, dans lequel le traitement électrochimique est une anodisation.

3. Procédé de réalisation selon la revendication 1 ou 2, dans lequel le premier substrat (2) est en un matériau semi-conducteur monocristallin.

4. Procédé de réalisation selon l'une des revendications 1 à 3, comportant, entre l'étape d) et l'étape e), une étape d1) d'oxydation d'au moins la zone traitée (12) et l'étape e) est une étape de retrait de la zone oxydée.

5. Procédé de réalisation selon la revendication 4, dans lequel l'étape d1) comporte une première sous-étape d'oxydation à une première température et une deuxième sous-étape d'oxydation à une deuxième température, la deuxième température étant supérieure à la première température , la première température étant avantageusement comprise entre 400°C et 500°C et la deuxième température étant avantageusement supérieure à 500°C.

6. Procédé de réalisation selon l'une des revendications 1 à 5, dans lequel lors de l'étape a), préalablement à la gravure, une autre couche de matériau de protection (4) est déposée sur la face avant du premier substrat (2), ledit matériau de protection étant apte à protéger la face avant contre le traitement physicochimique de l'étape d).

7. Procédé de réalisation selon l'une des revendications 1 à 6, dans lequel le matériau de la ou des couches de protection (4, 10, 16) est un matériau diélectrique ou un matériau métallique et/ou l'épaisseur de la ou des couches de protection (4, 10, 16) est comprise entre quelques dizaines et quelques centaines de nanomètres.

8. Procédé de réalisation selon l'une des revendications 1 à 7, dans lequel lors de l'étape a), préalablement à la première gravure, une première couche de résine (14) est déposée sur la face avant du premier substrat (2), ladite première couche de résine (14) étant retirée après la première gravure et avant l'étape b), et lors de l'étape c), préalablement à la deuxième gravure, une deuxième couche de résine (18) est déposée sur la couche de matériau de protection (16), ladite deuxième couche de résine (18) étant retirée après la deuxième gravure.

9. Procédé de réalisation d'une structure microélectromécanique et/ou nanoélectromécanique comportant au moins une première et une deuxième partie suspendue, dans un ensemble comportant un premier substrat (2) dont au moins la face avant est au moins en partie en matériau semi-conducteur, un deuxième substrat (28, 40) et des zones en matériau diélectrique et/ou des zones en matériau conducteur ou semi-conducteur situées à l'interface entre le premier substrat (2) et le deuxième substrat (28, 40), la première et la deuxième partie suspendue étant réalisées dans un moins une desdites faces du premier substrat, au moins la première partie suspendue étant obtenue suivant le procédé selon les revendications 1 à 8.

10. Procédé de réalisation selon la revendication 9, dans lequel le deuxième substrat est reporté sur le premier substrat avant la réalisation de la deuxième partie suspendue par gravure, ladite deuxième partie étant réalisée en face avant ou en face arrière du premier substrat, lesdites première et deuxième parties étant libérées après le report du deuxième substrat sur le premier substrat.

11. Procédé de réalisation selon la revendication 9 ou 10, comportant une étape de gravure du premier substrat (2) au niveau de sa face arrière pour atteindre la zone traitée (12) et/ou oxydée (112).

12. Procédé selon l'une des revendications 9 à 11, dans lequel la libération de la première partie suspendue (6) et la libération de la deuxième partie suspendue (34, 50) sont simultanées et réalisées à partir de la face avant, les libérations de la première partie suspendue (34) et de la deuxième partie suspendue (50) s'effectuant avantageusement par retrait d'oxyde.

13. Procédé de réalisation selon l'une des revendications 9 à 12, dans lequel la deuxième gravure de l'étape c) atteint l'interface entre le premier et le deuxième substrat.

14. Procédé selon la revendication 13 en combinaison avec la revendication 4 ou 5, dans lequel le ou les matériaux de protection sont retirés à la fin de l'étape d1) et au moins l'extrémité ouverte des tranchées (8) est bouchée préalablement à l'étape de réalisation de la deuxième partie suspendue lorsque les première et deuxième parties suspendues sont formées sur la face avant, l'extrémité ouverte des tranchées (8) étant avantageusement bouchée par le dépôt d'un oxyde (32), avantageusement un oxyde TEOS.

15. Procédé selon l'une des revendications 9 à 14 dans lequel la deuxième partie suspendue (50) est réalisée par gravure en face arrière du premier substrat (2).

16. Procédé selon la revendication 15, dans lequel une couche d'oxyde (36) est formée sur la face avant du premier substrat (2) avant son assemblage avec le deuxième substrat (40), formant une couche d'arrêt pour la gravure de la deuxième partie suspendue, la libération de la première partie suspendue (6) se faisant avantageusement par retrait de la zone traitée (12) ou oxydée (112) et la libération de la deuxième partie suspendue (50) se faisant avantageusement par retrait de ladite couche d'oxyde (36), lesdites libérations étant simultanées.

## Patentansprüche

1. Verfahren zum Herstellen zumindest eines ersten abgehängten Teils einer mikroelektronischen oder nanoelektronischen Struktur ausgehend von einem monolithischen Teil eines ersten Substrats (2), das eine Vorderseite und eine Rückseite aufweist, wobei das Verfahren die Schritte umfasst:
a) Durchführen einer ersten Ätzung mit einer ersten vorgegebenen Tiefe (p1) in der Vorderseite, so dass der erste abgehängte Teil (6) durch Gräben (8) begrenzt wird, wobei die Gräben (8) von Seitenkanten (8.1) und von einem Boden begrenzt werden,
b) Abscheiden eines Schutzmaterials (10, 16) zumindest auf den Seitenkanten der Gräben (8), die die Flanken des ersten abgehängten Teils (6) bilden, wobei das Schutzmaterial dazu geeignet ist, die Seitenkanten vor einer nachträglichen physikochemischen Behandlung zu schützen,
c) Durchführen einer zweiten Ätzung zumindest im Boden der Gräben (8), so dass Gräben mit einer zweiten Tiefe (p2) erhalten werden, die größer als die erste Tiefe (p1) ist, wobei die Seitenkanten dann einen mit dem Schutzmaterial bedeckten Teil und einen nicht mit dem Schutzmaterial bedeckten Teil aufweisen,
d) Durchführen einer physikochemischen Behandlung des ersten Substrats (2) in dem Teil der Seitenkanten, der nicht mit dem Schutzmaterial bedeckt ist, so dass zumindest teilweise ein Bereich des Substrats, der sich gegenüber der Vorderseite in Bezug auf den ersten abgehängten Teil (6) befindet, behandelter Bereich (12) genannt, modifiziert wird ,
e) Freilegen des ersten abgehängten Teils (6) durch Entfernen zumindest des in Schritt d) behandelten Bereichs,
wobei das Verfahren **dadurch gekennzeichnet ist, dass**
die physikochemische Behandlung ausgewählt ist aus einer elektrochemischen Behandlung oder einer teilweisen isotropen Ätzung.

2. Herstellungsverfahren nach Anspruch 1,
wobei die elektrochemische Behandlung ein Anodisieren ist.

3. Herstellungsverfahren nach Anspruch 1 oder 2,
wobei das erste Substrat (2) ein monokristallines Halbleitermaterial ist.

4. Herstellungsverfahren nach einem der Ansprüche 1 bis 3,
umfassend zwischen Schritt d) und Schritt e) einen Schritt d1) des Oxidierens zumindest von dem behandelten Bereich (12), wobei der Schritt e) ein Schritt des Entfernens des oxidierten Bereichs ist.

5. Herstellungsverfahren nach Anspruch 4,
wobei der Schritt d1) einen ersten Unterschritt des Oxidierens bei einer ersten Temperatur und einen zweiten Unterschritt des Oxidierens bei einer zweiten Temperatur umfasst, wobei die zweite Temperatur höher als die erste Temperatur ist, wobei die erste Temperatur vorteilhaft zwischen 400 °C und 500 °C beträgt und die zweite Temperatur vorteilhaft höher als 500 °C ist.

6. Herstellungsverfahren nach einem der Ansprüche 1 bis 5,
wobei in Schritt a) vor dem Ätzen eine weitere Schutzmaterialschicht (4) auf der Vorderseite des ersten Substrats (2) abgeschieden wird, wobei das Schutzmaterial dazu geeignet ist, die Vorderseite vor der physiochemischen Behandlung von Schritt d) zu schützen.

7. Herstellungsverfahren nach einem der Ansprüche 1 bis 6,
wobei das Material der Schutzschicht bzw. Schutzschichten (4, 10, 16) ein dielektrisches Material oder ein metallisches Material ist und/oder die Dicke der Schutzschicht bzw. Schutzschichten (4, 10, 16) zwischen mehreren zehn und mehreren hundert Nanometer beträgt.

8. Herstellungsverfahren nach einem der Ansprüche 1 bis 7,
wobei in Schritt a) vor dem ersten Ätzen eine erste Harzschicht (14) auf der Vorderseite des ersten Substrats (2) abgeschieden wird, wobei die erste Harzschicht (14) nach dem ersten Ätzen und vor dem Schritt b) entfernt wird,
und
in Schritt c) vor dem zweiten Ätzen eine zweite Harzschicht (18) auf der Schutzmaterialschicht (16) abgeschieden wird, wobei die zweite Harzschicht (18) nach dem zweiten Ätzen entfernt wird.

9. Verfahren zum Herstellen einer mikroelektromechanischen und/oder nanoelektromechanischen Struktur, enthaltend zumindest einen ersten und einen zweiten abgehängten Teil in einer Anordnung mit einem ersten Substrat (2), von dem zumindest die Vorderseite zumindest teilweise aus Halbleitermaterial besteht, und mit einem zweiten Substrat (28, 40) und Bereichen aus dielektrischem Material und/oder Bereichen aus Leiter- oder Halbleitermaterial, die an der Grenzfläche zwischen dem ersten Substrat (2) und dem zweiten Substrat (28, 40) liegen, wobei der erste und der zweite abgehängte Teil in zumindest einer der Seiten des ersten Substrats ausgeführt sind, wobei zumindest der erste abgehängte Teil gemäß dem Verfahren nach den Ansprüchen 1 bis 8 erhalten wird.

10. Herstellungsverfahren nach Anspruch 9, wobei vor dem Herstellen des zweiten abgehängten Teils durch Ätzen das zweite Substrat auf das erste Substrat aufgebracht wird, wobei der zweite Teil auf der Vorderseite oder Rückseite des ersten Substrats hergestellt wird, wobei der erste und der zweite Teil nach dem Aufbringen des zweiten Substrats auf das erste Substrat freigelegt werden.

11. Herstellungsverfahren nach Anspruch 9 oder 10, umfassend einen Schritt des Ätzens des ersten Substrats (2) im Bereich seiner Rückseite, um den behandelten (12) und/oder oxidierten Bereich (112) zu erhalten.

12. Verfahren nach einem der Ansprüche 9 bis 11,
wobei das Freilegen des ersten abgehängten Teils (6) und das Freilegen des zweiten abgehängten Teils (34, 50) gleichzeitig und ausgehend von der Vorderseite erfolgen, wobei das Freilegen des ersten abgehängten Teils (34) und das Freilegen des zweiten abgehängten Teils (50) vorteilhaft durch Entfernen von Oxid erfolgen.

13. Herstellungsverfahren nach einem der Ansprüche 9 bis 12,
wobei das zweite Ätzen von Schritt c) die Grenzfläche zwischen dem ersten und dem zweiten Substrat erreicht.

14. Verfahren nach Anspruch 13 in Kombination mit Anspruch 4 oder 5, wobei das bzw. die Schutzmaterialien am Ende von Schritt d1) entfernt werden und zumindest das offene Ende der Gräben (8) vor dem Schritt des Herstellens des zweiten abgehängten Teils verschlossen wird, wenn der erste und der zweite abgehängte Teil an der Vorderseite ausgebildet werden, wobei das offene Ende der Gräben (8) vorteilhaft durch Abscheiden eines Oxids (32), vorteilhaft eines TEOS-Oxids, verschlossen wird.

15. Verfahren nach einem der Ansprüche 9 bis 14,
wobei der zweite abgehängte Teil (50) durch Ätzen auf der Rückseite des ersten Substrats (2) hergestellt wird.

16. Verfahren nach Anspruch 15,
wobei eine Oxidschicht (36) auf der Vorderseite des ersten Substrats (2) vor dessen Zusammenfügen mit dem zweiten Substrat (40) ausgebildet wird, die eine Stoppschicht für das Ätzen des zweiten abgehängten Teils bildet, wobei das Freilegen des ersten abgehängten Teils (6) vorteilhaft durch Entfernen des behandelten (12) oder oxidierten Bereichs (112) erfolgt und das Freilegen des zweiten abgehängten Teils (50) vorteilhaft durch Entfernen der Oxidschicht (36) erfolgt, wobei die Freilegungen gleichzeitig erfolgen.

## Claims

1. A method for making at least one first suspended part of a microelectronic or nanoelectronic structure from a monolithic part of a first substrate (12) comprising a front face and a back face, said method comprising the following steps:
a) make a first etching with a first given depth (pi) in the front face so as to delimit the first suspended part (6) by trenches (8), the trenches (8) being delimited by side edges (8.1) and a bottom,
b) deposit a protective material (10, 16) on at least the side edges of the trenches (8) forming the flanks of the first suspended part (6), said protective material being capable of protecting said side edges against a subsequent physicochemical treatment,
c) make a second etching at least in the bottom of the trenches so as to obtain trenches (8) with a second depth (p2) greater than the first depth (pi), the side edges then comprising a part covered by the protective material and a part not covered by the protective material,
d) make a physicochemical treatment of the first substrate (2) in the part of the side edges not covered by the protective material so as to at least partly modify a zone of the substrate placed opposite the front face relative to the first suspended part (6), called the treated zone (12),
e) release the first suspended part (6) by removal of at least the zone treated in step d),
the method being **characterized in that** the physicochemical treatment is chosen from an electrochemical treatment and a partial isotropic etching.

2. The method according to claim 1, in which the treatment is an anodization.

3. The method according to claim 1 or 2, in which the first substrate (2) is a monocrystalline semiconducting material.

4. The method according to one of the claims 1 to 3, comprising, a step d1) to oxidize at least the treated zone (12) between step d) and step e), and step e) is a step to remove the oxidized zone.

5. The method according to claim 4, in which step d1) comprises a first oxidation sub-step at a first temperature and a second oxidation sub-step at a second temperature, the second temperature being higher than the first temperature, the first temperature being advantageously between 400°C and 500°C and the second temperature is higher than 500°C.

6. The method according to one of the claims 1 to 5, in which in step a), before etching, another layer of protective material, is deposited on the front face of the first substrate, said protective material being capable of protecting the front face against the physicochemical treatment in step d).

7. The method according to one of the claims 1 to 6, in which the material from which the protective layer(s) (4, 10, 16) is (are) made is a dielectric material or a metallic material and/or the thickness of the protective layer(s) (4, 10, 16) is between a few tens of nanometers and a few hundred nanometers.

8. The method according to one of the claims 1 to 7, in which in step a) before the first etching, a first resin layer is deposited on the front face of the first substrate (2), said first resin layer (14) being removed after the first etching and before step b), and a second resin layer (14) is deposited on the layer of protective material during step c), before the second etching, said second resin layer (18) being removed after the second etching.

9. A method of making a microelectromechanical and/or nanoelectromechanical structure comprising at least a first and a second suspended part, in an assembly comprising a first substrate (2) of which at least the front face is at least partially made of a semiconducting material, a second substrate (28, 40) and zones made of dielectric material and/or zones made of conducting or semiconducting material being located at the interface between the first substrate (2) and the second substrate (28, 40), the first and the second suspended part being made in at least one of said faces of the first substrate, at least the first suspended part being obtained using a method according to one of the claims 1 to 8.

10. The method according to claim 9, in which the second substrate is transferred onto the first substrate before the second suspended part is made by etching, said second part being made on the front face or the back face of the first substrate, said first and second parts being released after transfer of the second substrate onto the first substrate.

11. The method according to claim 9 or 10, comprising a step to etch the first substrate (2) at its back face to reach the treated zone (12) and/or the oxidized zone (112).

12. The method according to one of the claims 9 to 11, in which the first suspended part (6) and the second suspended (34, 50) part are released simultaneously and made starting from the front face, the first suspended part (34) and the second suspended (50) part being advantageously released by removal of oxide.

13. The method according to one of the claims 9 to 12, in which the second etching in step c) reaches the interface between the first and the second substrates.

14. The method according to claim 13, in combination with claim 4 or 5, in which the protective material(s) is (are) removed at the end of the step d1) and at least the open end of the trenches (8) is closed off before the step for production of the second suspended part when the first and second suspended parts are formed on the front face, the open end of the trenches (8) being advantageously close off by deposition of an oxide (32), advantageously a TEOS oxide.

15. The method according to one of the claims 9 to 14, in which the second suspended part (50) is made by etching the back face of the first substrate (2).

16. The method according to claim 15, in which an oxide layer (36) is formed on the front face of the first substrate (2) before it is assembled with the second substrate(40), forming a stop layer for etching the second suspended part, the first suspended part (6) being advantageously released by removal of the treated zone (12) or the oxidized zone (112) and the second suspended part (50) is released by removal of said oxide layer (36), said release operations being done simultaneously.
